(19) **Europäisches Patentamt / European Patent Office / Office européen des brevets**

(11) **EP 3 737 920 B1**

(12) **FASCICULE DE BREVET EUROPEEN**

(45) Date de publication et mention
de la délivrance du brevet:
**06.03.2024 Bulletin 2024/10**

(21) Numéro de dépôt: **19704039.7**

(22) Date de dépôt: **08.01.2019**

(51) Classification Internationale des Brevets (IPC):
**G01F 23/263** [(2022.01)]

(52) Classification Coopérative des Brevets (CPC):
**G01F 23/263; G01F 23/266**

(86) Numéro de dépôt international:
**PCT/FR2019/050033**

(87) Numéro de publication internationale:
**WO 2019/138181 (18.07.2019 Gazette 2019/29)**

(54) **DISPOSITIF DE MESURES CAPACITIVES DANS UN MILIEU MULTIPHASIQUE**

VORRICHTUNG ZUR KAPAZITIVEN MESSUNG IN EINEM MEHRPHASIGEN MEDIUM

DEVICE FOR CAPACITIVE MEASUREMENTS IN A MULTI-PHASE MEDIUM

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.01.2018 FR 1850268**

(43) Date de publication de la demande:
**18.11.2020 Bulletin 2020/47**

(73) Titulaire: **Université Grenoble Alpes
38400 Saint-Martin-d'Hères (FR)**

(72) Inventeur: **THIBAULT, Pierre
38410 Saint Martin d'Uriage (FR)**

(74) Mandataire: **Hautier IP
20, rue de la Liberté
06000 Nice (FR)**

(56) Documents cités:
**EP-A1- 3 246 667     JP-A- 2000 065 775**

EP 3 737 920 B1

**Description**

**Domaine technique**

L'invention se rapporte au domaine technique des dispositifs de mesures capacitives dans un milieu multiphasique, le milieu multiphasique comportant des phases fluidiques distinctes de par leurs propriétés diélectriques, par exemple une phase aqueuse et au moins une phase organique.

Les dispositifs de mesures capacitives présentent l'avantage de pouvoir fonctionner à une seule fréquence de travail, contrairement aux dispositifs de mesures d'impédance (e.g. par spectroscopie d'impédance électrochimique) qui nécessitent un balayage complet des fréquences.

L'invention trouve notamment son application dans :

- la détection de présence d'une phase aqueuse au sein d'un milieu multiphasique comportant au moins une phase organique (e.g. huile, kérosène, fuel...),
- la détermination de la hauteur de la phase aqueuse dans un réservoir contenant un milieu multiphasique comportant au moins une phase organique (e.g. huile, kérosène, fuel...),
- la détermination de la hauteur de couches sédimentées ou surnageant dans un séparateur de phase (e.g. boues, graisses...),
- la surveillance du séchage d'un milieu multiphasique poreux (e.g. béton, sol humide...).

**Etat de la technique antérieure**

Un dispositif de mesures capacitives connu de l'état de la technique, notamment du document US 7,258,005, comporte :

- au moins un couple d'électrodes d'excitation, formant un condensateur, et destiné à être insérés dans le milieu multiphasique ;
- un plan de masse ;
- un circuit électronique, agencé pour connecter électriquement le couple d'électrodes d'excitation au plan de masse, et configuré pour :

    appliquer un potentiel électrique à chaque électrode d'excitation à une fréquence de travail, et
    mesurer une capacité mutuelle entre le couple d'électrodes d'excitation.

Un tel dispositif de l'état de la technique n'est pas entièrement satisfaisant dans la mesure où il nécessite un agencement géométrique particulier des électrodes d'excitation, en particulier un espacement entre elles supérieur ou égal à deux fois l'épaisseur des parois diélectriques d'un réservoir contenant le milieu multiphasique (cf. revendication 1 ; col.5, 1.21-25 ; col.6, 1.4-5). Si l'espacement entre les électrodes d'excitation est plus faible que deux fois l'épaisseur des parois diélectriques du réservoir, la dépendance de la valeur de la capacité mutuelle relativement à la hauteur de fluide décroît (cf. col.6, 1.7-8), d'où une perte de sensibilité et de précision dans la mesure.

**Exposé de l'invention**

L'invention vise à remédier en tout ou partie aux inconvénients précités. A cet effet, l'invention a pour objet un dispositif de mesures capacitives dans un milieu multiphasique, comportant :

- au moins un couple d'électrodes d'excitation, formant un condensateur ;
- un plan de masse ;
- un circuit électronique, agencé pour connecter électriquement le couple d'électrodes d'excitation au plan de masse, et configuré pour :

    appliquer un potentiel électrique à chaque électrode d'excitation à une fréquence de travail, et
    mesurer une capacité mutuelle entre le couple d'électrodes d'excitation ;

le dispositif étant remarquable en ce qu'il comporte :

- au moins une électrode de contrôle, agencée à une distance du condensateur, et destinée à être insérée dans le milieu multiphasique ;

- un circuit de commutation comprenant un commutateur présentant un état ouvert et un état fermé dans lesquels le commutateur respectivement déconnecte et connecte électriquement l'électrode de contrôle au plan de masse ; le circuit de commutation étant configuré pour :

appliquer à l'électrode de contrôle un potentiel électrique commun au plan de masse, lorsque le commutateur est dans l'état fermé, et
laisser un potentiel électrique flottant pour l'électrode de contrôle, lorsque le commutateur est dans l'état ouvert ;

et en ce que le circuit électronique est configuré pour mesurer la capacité mutuelle entre le couple d'électrodes d'excitations lorsque le commutateur est dans l'état ouvert et lorsque le commutateur est dans l'état fermé.

Ainsi, un tel dispositif selon l'invention permet, grâce à l'électrode de contrôle, de détecter la présence d'une phase électriquement conductrice à la fréquence de travail dès lors que la capacité mutuelle mesurée lorsque le commutateur est dans l'état ouvert est différente de la capacité mutuelle mesurée lorsque le commutateur est dans l'état fermé.

En outre, un tel dispositif selon l'invention permet, grâce à l'électrode de contrôle, de déterminer la hauteur de la phase détectée dans un réservoir à partir des capacités mutuelles mesurées lorsque le commutateur est dans l'état ouvert et dans l'état fermé.

Enfin, un tel dispositif selon l'invention fonctionne sans contrainte spécifique vis-à-vis de l'espacement entre les électrodes d'excitations, contrairement à l'état de la technique.

**Définitions**

- Par « milieu multiphasique », on entend un milieu comportant des phases distinctes de par leurs propriétés diélectriques. Les phases ne sont pas nécessairement immiscibles. Le milieu multiphasique peut comporter des phases fluidiques et/ou des phases solides, par exemple lorsque le milieu multiphasique est poreux.
- Par « plan de masse », on entend tout moyen d'obtenir un potentiel de référence pour le dispositif.
- Par « capacité mutuelle» (*transcapacitance* en langue anglaise), on entend la capacité électrique entre le couple d'électrodes d'excitation, c'est-à-dire le rapport entre la quantité de charges électriques portée par une électrode d'excitation et la différence de potentiels entre les deux électrodes d'excitation. La capacité mutuelle est donc distincte de la capacité électrique entre l'une quelconque des électrodes d'excitation et le plan de masse.

Le dispositif selon l'invention peut comporter une ou plusieurs des caractéristiques suivantes.

Selon une caractéristique de l'invention, le milieu multiphasique comporte une phase comprenant des espèces électriquement conductrices à la fréquence de travail ; lesdites espèces possédant une fréquence de coupure, en-dessous de laquelle lesdites espèces égalisent le potentiel électrique, laissé flottant, dans le milieu multiphasique sur la distance à laquelle est agencée l'électrode de contrôle du condensateur ;
et la fréquence de travail est choisie de manière à être inférieure ou égale à la fréquence de coupure.

Par « égaliser », on entend :

- soit une égalisation stricte du potentiel électrique, laissé flottant, dans le milieu multiphasique sur la distance à laquelle est agencée l'électrode de contrôle du condensateur ; ou
- soit une égalisation approximative du potentiel électrique, laissé flottant, dans le milieu multiphasique sur la distance à laquelle est agencée l'électrode de contrôle du condensateur, de sorte que la différence de potentiels entre la phase électriquement conductrice (à la fréquence de travail) et l'électrode de contrôle reste négligeable.

Ainsi, un avantage procuré est d'améliorer la fiabilité du dispositif en cas de détection de présence de phase, et d'améliorer la précision de la mesure en cas de détermination de la hauteur de la phase dans un réservoir par exemple.

Selon une caractéristique de l'invention, le condensateur présente une distance caractéristique, notée d ;
et la distance à laquelle est agencée l'électrode de contrôle du condensateur, notée l, est choisie de sorte que :

$$0 < l < 100 \times d\,\frac{f_c}{f}, \text{de préférence} : 0 < l < 10 \times d\,\frac{f_c}{f}$$

où :

- $f_c$ est la fréquence de coupure,

- f est la fréquence de travail.

Ainsi, on pourra choisir une distance l importante (i.e. proche de 100 d $f_c$/f) dès lors que le circuit électronique est très performant en termes de précision de mesure de la capacité mutuelle entre le couple d'électrodes d'excitation. A l'inverse, on choisira une distance l plus réduite (i.e. jusqu'à 10 d $f_c$/f) dès lors que le circuit électronique possède des performances classiques en termes de précision de mesure de la capacité mutuelle entre le couple d'électrodes d'excitation.

Selon une caractéristique de l'invention, le dispositif comporte un ensemble d'électrodes de contrôle, agencées à des distances différentes du condensateur, et destinées à être insérées dans le milieu multiphasique ; le circuit de commutation comportant un commutateur dédié à chaque électrode de contrôle.

Ainsi, un avantage procuré est de pouvoir étudier spatialement, au sein du milieu multiphasique, la présence ou la quantité de la phase électriquement conductrice à la fréquence de travail. A titre d'exemple, il est alors possible de surveiller l'état de séchage d'un milieu multiphasique poreux et humide.

Selon une caractéristique de l'invention, le circuit électronique comporte une masse virtuelle reliée à une électrode d'excitation ; et le circuit électronique est configuré pour mesurer la capacité mutuelle entre le couple d'électrodes d'excitation par une méthode de type trois fils ou quatre fils.

Ainsi, un avantage procuré par la masse virtuelle, et la méthode de type trois fils ou quatre fils, est de pouvoir s'affranchir des capacités parasites entre une électrode d'excitation et le plan de masse, ainsi que de l'impédance d'un fil, de manière à obtenir une mesure précise de la capacité mutuelle entre le couple d'électrodes d'excitation.

Selon une caractéristique de l'invention, le circuit électronique comporte un amplificateur opérationnel, monté en inverseur, et comprenant :

- une entrée non-inverseuse, reliée au plan de masse ;
- une entrée inverseuse, reliée à une électrode d'excitation.

Ainsi, un avantage procuré est l'obtention aisée d'une masse virtuelle. En d'autres termes, un tel montage permet de mettre virtuellement à la masse ladite électrode d'excitation reliée à l'entrée inverseuse, lorsque l'amplificateur opérationnel fonctionne en régime linéaire.

Selon une caractéristique de l'invention, le dispositif comporte :

- une couche diélectrique, comprenant une première surface et une deuxième surface opposée ; le couple d'électrodes d'excitation s'étendant à la première surface de la couche diélectrique ;
- une contre-électrode, s'étendant à la deuxième surface de la couche diélectrique, et formant le plan de masse.

Ainsi, un avantage procuré est de pouvoir insérer dans le milieu multiphasique l'ensemble formé par le couple d'électrodes d'excitation, la couche diélectrique, et la contre-électrode. La couche diélectrique permet d'isoler électriquement le couple d'électrode d'excitation et la contre-électrode entre elles.

Selon une caractéristique de l'invention, le couple d'électrodes d'excitation est recouvert d'un film diélectrique.

Ainsi, un avantage procuré est de protéger le couple d'électrodes d'excitation du milieu multiphasique.

Selon une caractéristique de l'invention, le condensateur formé par le couple d'électrodes d'excitation est sélectionné parmi un condensateur à plaques parallèles, un condensateur à électrodes interdigitées, un condensateur à cylindres coaxiaux.

Un avantage procuré par le condensateur à électrode interdigitées est d'empêcher dans une moindre mesure le déplacement des ions électriquement conducteurs (présent notamment dans le condensateur à plaques parallèles et à cylindres coaxiaux), ce qui permet de relier plus facilement le potentiel électrique, laissé flottant, dans le milieu multiphasique sur la distance (l) à laquelle est agencée l'électrode de contrôle du condensateur. Ce potentiel flottant pourra être obtenu par utilisation d'un système électrique possédant une très grande impédance vis-à-vis d'un réservoir de charges, comme celle d'un amplificateur opérationnel.

La présence de gradients de potentiel a été observée dans le milieu multiphasique pour le condensateur à plaques parallèles si l'on augmente la distance l. En d'autres termes, un condensateur à électrodes interdigitées permet d'avoir une plus grande liberté sur la distance à laquelle est agencée l'électrode de contrôle du condensateur.

Un autre avantage procuré par le condensateur à électrodes interdigitées est de réduire les effets de double couche électrique en paroi (présents notamment dans le condensateur à plaques parallèles et à cylindres coaxiaux), et qui tendent à augmenter la valeur de la capacité mutuelle lorsque le commutateur est dans l'état ouvert.

L'invention a également pour objet une installation, comportant :

- un réservoir comportant un milieu multiphasique ;
- un dispositif conforme à l'invention, l'électrode de contrôle étant insérée dans le milieu multiphasique.

L'invention a également pour objet un système de mesures capacitives dans un milieu multiphasique, comportant :

- un dispositif de flottaison, destiné à flotter dans le milieu multiphasique ;
- au moins un dispositif conforme à l'invention, monté solidaire du dispositif de flottaison.

Ainsi, un tel système selon l'invention permet d'effectuer des mesures capacitives pertinentes lorsque la hauteur du milieu multiphasique n'est pas constante au cours du temps, en prenant une hauteur de référence relative à la surface libre du milieu multiphasique grâce à la présence du dispositif de flottaison. Il est alors rendu possible la détermination précise de la hauteur de couches sédimentées ou surnageant dans un séparateur de phase (e.g. hydrocarbures, boues légères, graisses...) tel qu'une station (ou micro-station) d'épuration. En effet, pour ce type d'applications, la position de la surface libre de la phase supérieure du milieu multiphasique peut varier au cours du temps, en raison des variations du débit de liquide (eau) et de la quantité des hydrocarbures surnageant. Les mesures capacitives fournies par un tel système selon l'invention permettent de déterminer à quel moment intervenir pour ôter une phase polluante (généralement par pompage) en détectant la phase polluante. Il est en effet important de pouvoir planifier ce genre d'interventions qui sont coûteuses et dont le manquement peut conduire à une pollution par rejet dans l'environnement. Par ailleurs, les mesures capacitives fournies par un tel système selon l'invention permettent de n'ôter que la quantité strictement nécessaire de la phase polluante en contrôlant la hauteur de la phase polluante.

Selon une caractéristique de l'invention, le dispositif de flottaison comporte une paroi de séparation avec le milieu multiphasique, la paroi possédant une surface interne, et le dispositif de mesures capacitives est monté à l'intérieur de la paroi, en appui contre la surface interne.

**Brève description des dessins**

D'autres caractéristiques et avantages apparaîtront dans l'exposé détaillé de différents modes de réalisation de l'invention, l'exposé étant assorti d'exemples et de références aux dessins joints.

Figure 1 est une vue schématique illustrant la circuiterie d'un dispositif selon l'invention.
Figure 2 est une vue schématique en perspective, illustrant un mode de réalisation d'un dispositif selon l'invention.
Figure 3 est une vue schématique en perspective, illustrant un mode de réalisation d'un dispositif selon l'invention.
Figure 4 est une vue schématique en perspective, illustrant un mode de réalisation d'un dispositif selon l'invention.
Figure 5 est une vue schématique en perspective, illustrant un mode de réalisation d'un dispositif selon l'invention.
Figure 6 est une vue schématique en coupe, illustrant un mode de réalisation d'un dispositif selon l'invention.
Figure 7 est un graphique représentant en abscisse le niveau d'huile observé (en mm), et en ordonnée le niveau des phases (en mm) déterminé à partir des mesures capacitives d'un dispositif selon l'invention. « A » est une phase aqueuse, « B » est une phase d'huile, « C » est une phase d'air.
Figure 8 est un graphique représentant en abscisse le niveau d'eau observé (en % de la hauteur totale du milieu multiphasique), et en ordonnée le niveau des phases (en % de la hauteur totale du milieu multiphasique) déterminé à partir des mesures capacitives d'un dispositif selon l'invention. « A » est une phase aqueuse, « B » est une phase d'huile, « C » est une phase d'air.
Figures 9a à 9e sont des vues schématiques en coupe, illustrant différents modes de réalisation d'un système selon l'invention.

**Exposé détaillé des modes de réalisation**

Les éléments identiques ou assurant la même fonction porteront les mêmes références pour les différents modes de réalisation, par souci de simplification.

Un objet de l'invention est un dispositif de mesures capacitives dans un milieu M multiphasique, comportant :

- au moins un couple d'électrodes d'excitation 1, 2, formant un condensateur ;
- un plan de masse PM ;
- un circuit électronique 3, agencé pour connecter électriquement le couple d'électrodes d'excitation 1, 2 au plan de masse PM, et configuré pour :

appliquer un potentiel électrique V+, V_ à chaque électrode d'excitation 1, 2 à une fréquence de travail, et mesurer une capacité mutuelle entre le couple d'électrodes d'excitation 1, 2 ;

le dispositif étant remarquable en ce qu'il comporte :

- au moins une électrode de contrôle 4, agencée à une distance l du condensateur, et destinée à être insérée dans le milieu multiphasique M ;
- un circuit de commutation 5 comprenant un commutateur 50 présentant un état ouvert et un état fermé dans lesquels le commutateur 50 respectivement déconnecte et connecte électriquement l'électrode de contrôle 4 au plan de masse PM ; le circuit de commutation 5 étant configuré pour :

  appliquer à l'électrode de contrôle 4 un potentiel électrique commun au plan de masse PM, lorsque le commutateur 50 est dans l'état fermé, et

  laisser un potentiel électrique flottant pour l'électrode de contrôle 4, lorsque le commutateur 50 est dans l'état ouvert ;

et en ce que le circuit électronique 3 est configuré pour mesurer la capacité mutuelle entre le couple d'électrodes d'excitations 1, 2 lorsque le commutateur 50 est dans l'état ouvert et lorsque le commutateur 50 est dans l'état fermé.

## Milieu multiphasique

Le milieu multiphasique M comporte des espèces formant des phases $P_1$, $P_2$, $P_3$. Lesdites espèces possèdent une fréquence de coupure, en-dessous de laquelle lesdites espèces égalisent le potentiel électrique, laissé flottant, dans le milieu multiphasique M sur la distance l à laquelle est agencée l'électrode de contrôle 4 du condensateur. Il est supposé que l'une des espèces est électriquement conductrice à la fréquence de travail. A titre d'exemple, la fréquence de travail peut être choisie à 1 kHz pour détecter la présence d'une phase $P_1$ aqueuse. Le milieu multiphasique M impose le potentiel électrique (laissé flottant par le commutateur 50) à l'électrode de contrôle 4 lorsque le commutateur 50 est dans l'état ouvert.

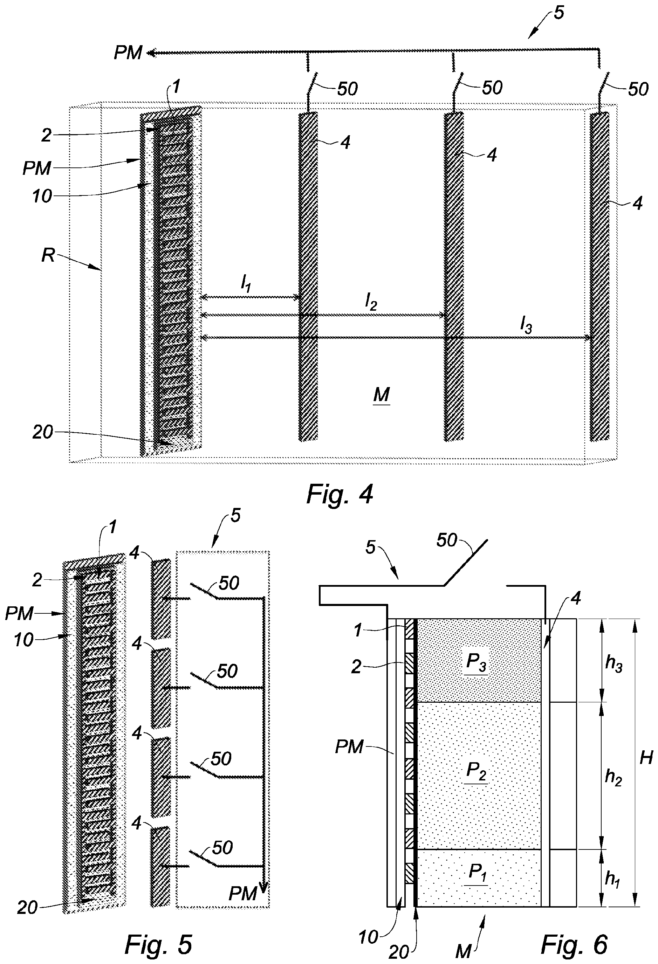

Dans le cas illustré à la figure 6, le milieu multiphasique M comporte trois phases $P_1$, $P_2$, $P_3$ stratifiées, distinctes de par leurs propriétés diélectriques, et présentant respectivement une hauteur $h_1$, $h_2$, $h_3$ dans un réservoir R de hauteur H.

## Condensateur

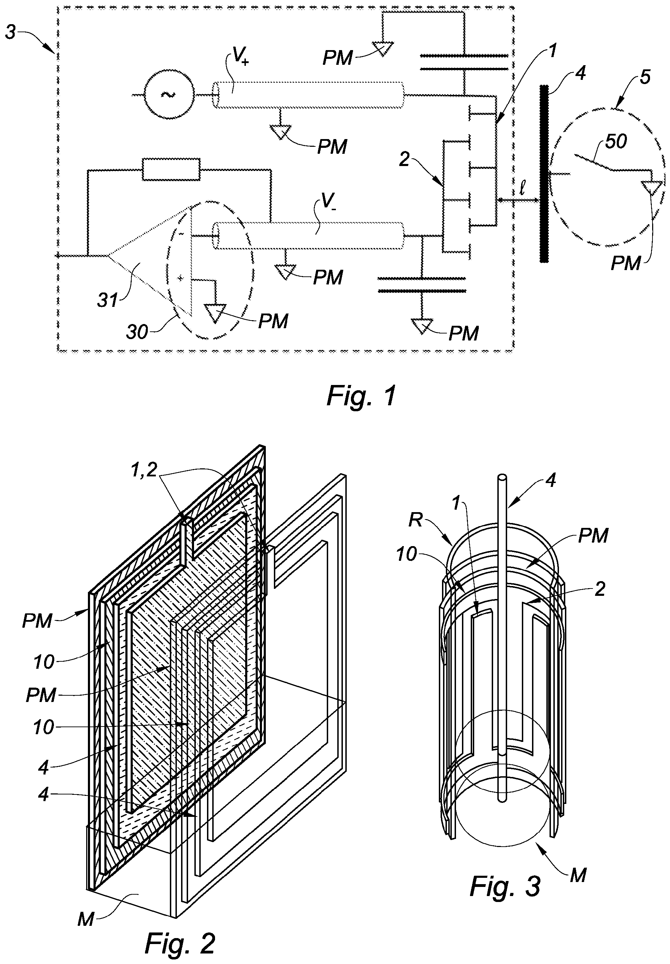

Le condensateur formé par le couple d'électrodes d'excitation 1, 2 est avantageusement sélectionné parmi un condensateur à plaques parallèles (comme illustré à la figure 2), un condensateur à électrodes interdigitées (comme illustré aux figures 4 à 6), un condensateur à cylindres coaxiaux (comme illustré à la figure 3).

Le condensateur présente une distance caractéristique, notée d. Par exemple, pour un condensateur à plaques parallèles, la distance caractéristique d est la distance séparant les deux plaques. Pour un condensateur à électrodes interdigitées, la distance caractéristique d est égale à $\lambda/4$, où $\lambda$ est la période de la structure interdigitée. Enfin, pour un condensateur à cylindres coaxiaux, la distance caractéristique d est la distance radiale entre les deux cylindres.

Les électrodes d'excitation 1, 2 peuvent être de différentes formes telles que planaires, cylindriques, interdigitées.

Le couple d'électrodes d'excitation 1, 2 est avantageusement recouvert d'un film diélectrique 20. A titre d'exemples non limitatifs, le film diélectrique 20 peut être réalisé dans un matériau diélectrique sélectionné parmi un polyimide, un polytétrafluoroéthylène, ou une résine photosensible.

A titre d'exemples non limitatifs, les électrodes d'excitation 1, 2 peuvent être réalisées dans un matériau métallique, de préférence sélectionné parmi Cu, Ag, Au, Al. Cependant, les électrodes d'excitation 1, 2 peuvent être réalisées dans un matériau plastique (e.g. un polyphtalamide) dans lequel ont été incorporées des fibres de carbone afin de rendre les électrodes d'excitation 1, 2 électriquement conductrices.

## Plan de masse

Le dispositif comporte avantageusement :

- une couche diélectrique 10, comprenant une première surface et une deuxième surface opposée ; le couple d'électrodes d'excitation 1, 2 s'étendant à la première surface de la couche diélectrique 10 ;
- une contre-électrode, s'étendant à la deuxième surface de la couche diélectrique 10, et formant le plan de masse PM.

Une telle couche diélectrique 10 permet d'isoler électriquement entre elles les électrodes d'excitation 1, 2 et la contre-électrode de manière à éviter de les mettre en court-circuit.

A titre d'exemple non limitatif, la contre-électrode peut être une plaque réalisée dans un matériau métallique. Le matériau métallique est de préférence sélectionné parmi Cu, Ag, Au, Al. Cependant, la contre-électrode peut être réalisée dans un matériau plastique (e.g. un polyphtalamide) dans lequel ont été incorporées des fibres de carbone afin de rendre la contre-électrode électriquement conductrice.

A titre d'exemples non limitatifs, la couche diélectrique peut être réalisée dans un matériau diélectrique sélectionné parmi un polyimide, ou un polytétrafluoroéthylène.

## Circuit électronique

La fréquence de travail, à laquelle le circuit électronique 3 applique un potentiel électrique $V_+$, $V_-$ à chaque électrode d'excitation 1, 2, est choisie de manière à être inférieure ou égale à la fréquence de coupure d'au moins une des phases $P_1$, $P_2$, $P_3$. Comme évoqué précédemment, la fréquence de travail peut être choisie à 1 kHz pour détecter la présence d'une phase $P_1$ aqueuse. Comme illustré à la figure 1, le circuit électronique 3 peut comporter une source d'excitation (e.g. un générateur de tension alternative) pour charger une électrode d'excitation 1 du couple afin de lui appliquer un potentiel électrique V+. L'autre électrode d'excitation 2 du couple peut alors être reliée au plan de masse PM afin de lui appliquer le potentiel électrique $V_-$.

Le circuit électronique 3 comporte avantageusement une masse virtuelle 30 reliée à une électrode d'excitation 1, 2. Le circuit électronique 3 est avantageusement configuré pour mesurer la capacité mutuelle entre le couple d'électrodes d'excitation 1, 2 par une méthode de type trois fils ou quatre fils.

Le circuit électronique 3 comporte avantageusement un amplificateur opérationnel 31, monté en inverseur, et comprenant :

- une entrée non-inverseuse, reliée au plan de masse PM ;
- une entrée inverseuse, reliée à une électrode d'excitation 2. L'amplificateur opérationnel 31 fonctionne en régime linéaire de manière à mettre virtuellement à la masse ladite électrode d'excitation 2 reliée à l'entrée inverseuse.

## Electrode(s) de contrôle

La distance à laquelle est agencée l'électrode de contrôle 4 du condensateur, notée l, est avantageusement choisie de sorte que :

$$0 < l < 100 \times d\,\frac{f_c}{f}, \text{de préférence}: 0 < l < 10 \times d\,\frac{f_c}{f}$$

où :

- $f_c$ est la fréquence de coupure,
- f est la fréquence de travail.

Comme illustré à la figure 4, le dispositif comporte avantageusement un ensemble d'électrodes de contrôle 4, agencées à des distances différentes $l_1$, $l_2$, $l_3$ du condensateur, et destinées à être insérées dans le milieu multiphasique M. Chacune des distances différentes (notée $l_i$) auxquelles sont agencées les électrodes de contrôle 4 de l'ensemble vérifient avantageusement :

$$0 < l_i < 100 \times d\,\frac{f_c}{f}, \text{de préférence}: 0 < l_i < 10 \times d\,\frac{f_c}{f}$$

Comme illustré à la figure 4, les électrodes de contrôle 4 de l'ensemble sont espacées horizontalement, ce qui permet d'étudier le milieu multiphasique M suivant cette dimension.

Comme illustré à la figure 5, le dispositif peut comporter un ensemble d'électrodes de contrôle 4, agencées à une même distance l du ou des condensateurs, et espacées verticalement de manière à être coplanaires, ce qui permet d'étudier le milieu multiphasique M suivant cette dimension.

L'électrode de contrôle 4 ou les électrodes de contrôle 4 peuvent être réalisées sous forme d'une grille, ou sous forme de méandres. Dans le cas d'une électrode de contrôle 4 réalisée sous forme d'une grille, un avantage procuré est de favoriser le contact avec la phase conductrice du milieu multiphasique M, répartie en surface ou en volume, par exemple lorsque la phase conductrice est une mousse ou une émulsion. Dans le cas d'une électrode de contrôle 4 réalisée sous la forme de méandres, celle-ci peut être avantageusement planaire, et parallèle aux électrodes d'excitation 1, 2 interdigitées. Le pas des méandres pourra être choisi de manière à détecter tout ou partie de la phase conductrice du milieu multiphasique M, lorsque la phase conductrice est répartie de manière alternée (par exemple lorsque des gouttes non connectées entre elles viennent mouiller une surface des méandres), et ce afin de détecter la fraction de la phase conductrice recouvrant les méandres.

A titre d'exemples non limitatifs, l'électrode de contrôle 4 ou les électrodes de contrôle 4 peuvent être réalisées dans un matériau métallique, de préférence sélectionné parmi Cu, Ag, Au, Al. Cependant, l'électrode de contrôle 4 ou les électrodes de contrôle 4 peuvent être réalisées dans un matériau plastique (e.g. un polyphtalamide) dans lequel ont été incorporées des fibres de carbone afin de rendre les électrodes de contrôle 4 électriquement conductrices.

### Circuit de commutation

Lorsque le dispositif comporte un ensemble d'électrodes de contrôle 4, le circuit de commutation 5 comporte un commutateur 50 dédié à chaque électrode de contrôle 4.

A titre d'exemples non limitatifs, le commutateur 50 peut être un interrupteur ou un relai électrique.

### Application à la détection de phase

Le dispositif selon l'invention peut être un détecteur de présence d'une des phases $P_1$, $P_2$, $P_3$ dès lors qu'il existe une différence entre la capacité mutuelle mesurée par le circuit électronique 3 entre le couple d'électrodes d'excitations 1, 2 lorsque le commutateur 50 est dans l'état ouvert (notée $C_{off}$), et lorsque le commutateur 50 est dans l'état fermé (notée $C_{on}$). La différence mesurée entre $C_{off}$ et $C_{on}$ traduit la différence de réponse diélectrique (en termes de permittivité électrique e) de la phase détectée lorsque celle-ci est excitée par un potentiel électrique extérieur ou non.

En pratique, on définira un seuil de détection pour la différence entre $C_{off}$ et $C_{on}$ au-delà duquel la présence de la phase est assurée.

### Application à la quantification de phase

On considère :

- un milieu multiphasique M comportant trois phases $P_1$, $P_2$, $P_3$ stratifiées, distinctes de par leurs propriétés diélectriques, et présentant respectivement une hauteur $h_1$, $h_2$, $h_3$ dans un réservoir R de hauteur H ;
- que la phase $P_1$ a une réponse diélectrique différenciée en présence d'un potentiel électrique extérieur.

En notant : $x_1 = {h_1}/{H}$ ; $x_2 = {h_2}/{H}$ ; $x_3 = {h_3}/{H}$

Il est possible d'établir les équations suivantes :

$$x_1 + x_2 + x_3 = 1$$

$$C_{off} = x_1 C_{1,off}^H + x_2 C_2^H + x_3 C_3^H$$

$$C_{on} = x_1 C_{1,on}^H + x_2 C_2^H + x_3 C_3^H$$

où :

- $C_2^H$ et $C_3^H$ sont les capacités mutuelles entre le couple d'électrodes d'excitation 1, 2 lorsque le réservoir R est respectivement rempli d'une phase $P_2$ et rempli d'une phase $P_3$,
- $C_{1,on}^H$ et $C_{1,off}^H$ sont les capacités mutuelles entre le couple d'électrodes d'excitation 1, 2 lorsque le réservoir R est rempli d'une phase $P_1$, et lorsque le commutateur 50 est respectivement dans l'état fermé et dans l'état ouvert.

Il est alors possible d'obtenir les relations suivantes :

$$x_1 = \frac{C_{on} - C_{off}}{C_{1,on}^H - C_{1,off}^H}$$

$$x_2 = \frac{\left(\left(C_{off} - x_1 C_{1,off}^H\right) - C_3^H(1 - x_1)\right)}{C_2^H - C_3^H}$$

$$x_3 = \frac{\left(\left(C_{on} - x_1 C_{1,on}^H\right) - C_2^H(1 - x_1)\right)}{C_3^H - C_2^H}$$

La valeur $x_1$ (et donc $h_1$) est parfaitement déterminée car :

- $C_{on}$ et $C_{off}$ sont des valeurs mesurées lors de l'acquisition,
- $C_{1,on}^H$ et $C_{1,off}^H$ sont des valeurs mesurées par étalonnage préalable (cf. section suivante).

De la même façon, il est possible de déterminer $x_2$ (et donc $h_2$) et $x_3$ (et donc $h_3$) à partir de mesures d'acquisition et de mesures d'étalonnage.

### Etalonnage du dispositif

Si le dispositif est utilisé en quantification de phase, il est nécessaire d'étalonner préalablement le dispositif afin de déterminer les valeurs de $C_{1,on}^H$, $C_{1,off}^H$, $C_2^H$, $C_3^H$.

Ces étalonnages peuvent également s'effectuer à partir de deux autres conditions de niveau connues, ou par similitude avec un autre milieu, ou encore par simulation numérique.

Il est possible d'étalonner le dispositif *in-situ,* en utilisant des capteurs capacitifs supplémentaires (capacités de compensation), et par des techniques connues de l'homme du métier.

### Installation

Un objet de l'invention est une installation, comportant :

- un réservoir R comportant le milieu multiphasique M ;
- un dispositif conforme à l'invention, l'électrode de contrôle 4 étant insérée dans le milieu multiphasique M.

Le terme « réservoir » s'entend de manière large et couvre tout support permettant de contenir le milieu multiphasique M.

Le réservoir R est avantageusement électriquement isolé du milieu multiphasique M afin de ne pas imposer de potentiel électrique à l'électrode de contrôle 4 (laissé flottant par le commutateur 50 dans l'état ouvert). Le potentiel électrique reste ainsi imposé par le milieu multiphasique M lorsque le commutateur 50 est dans l'état ouvert. Lorsque le réservoir R n'est pas électriquement isolé du milieu multiphasique M (e.g. un réservoir R à parois métalliques), alors le condensateur et l'électrode de contrôle 4 sont agencés à une distance suffisamment grande des parois métalliques du réservoir R de sorte que le réservoir R n'influence pas le potentiel électrique du milieu multiphasique M.

Le couple d'électrodes d'excitation 1, 2 peut être inséré dans le milieu multiphasique M. A titre de variante, le couple d'électrodes d'excitation 1, 2 peut être mis à l'extérieur d'une paroi diélectrique servant à contenir le milieu multiphasique M.

### Exemples de réalisation

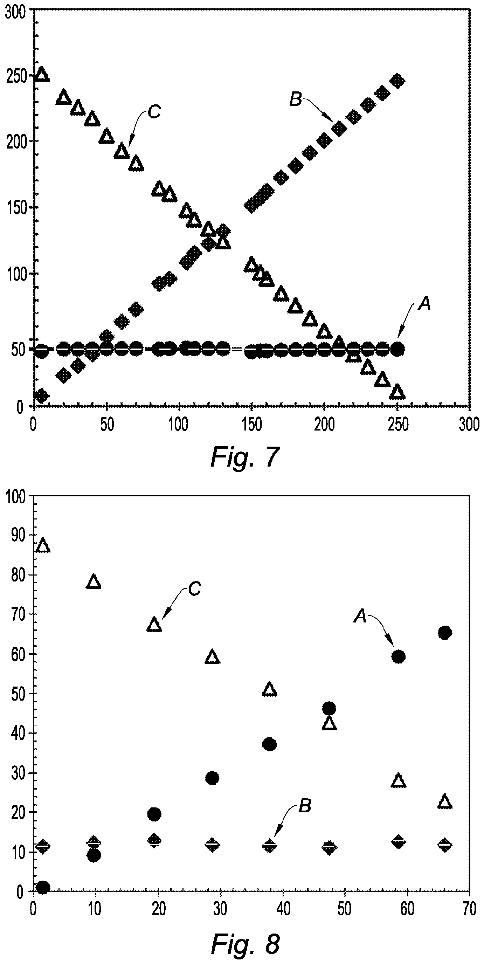

Comme illustré aux figures 7 et 8, des tests ont été effectués pour un milieu multiphasique M comportant une phase A aqueuse, une phase B d'huile et une phase C d'air dans un réservoir R de type éprouvette d'une hauteur H.

Le condensateur est formé par un couple d'électrodes d'excitation 1, 2 interdigitées. Chaque électrode d'excitation 1, 2 présente une largeur de 250 $\mu$m. La distance inter-électrodes est de 250 $\mu$m. Le condensateur présente une hauteur de 300 mm. Le condensateur s'étend sur une face d'une couche diélectrique 10 réalisée en polyimide. La couche diélectrique 10 présente une épaisseur de 25 $\mu$m. Le couple d'électrodes d'excitation 1, 2 est recouvert d'un film diélectrique 20 réalisé en polyimide. Le film diélectrique 20 présente une épaisseur de 25 $\mu$m.

La fréquence de travail est 1 kHz. La capacité mutuelle entre le couple d'électrodes d'excitation 1, 2 est mesurée à l'aide d'un RLC mètre.

L'étalonnage pour déterminer les valeurs $C_{A,on}^H$, $C_{A,off}^H$ est réalisé en remplissant l'éprouvette d'eau et en immergeant le couple d'électrodes d'excitation 1, 2 et l'électrode de contrôle 4 dans l'éprouvette. On observe le même protocole pour l'huile.

Dans le cas illustré à la figure 7, on verse progressivement de l'huile dans l'éprouvette contenant initialement de l'eau. Dans le cas illustré à la figure 8, on verse progressivement de l'eau dans l'éprouvette contenant initialement de l'huile. On constate dans les deux cas que les valeurs de niveaux de fluide déterminées à partir des mesures capacitives du dispositif selon l'invention coïncident avec les niveaux de fluide observés à l'œil.

## Système de mesures avec dispositif de flottaison

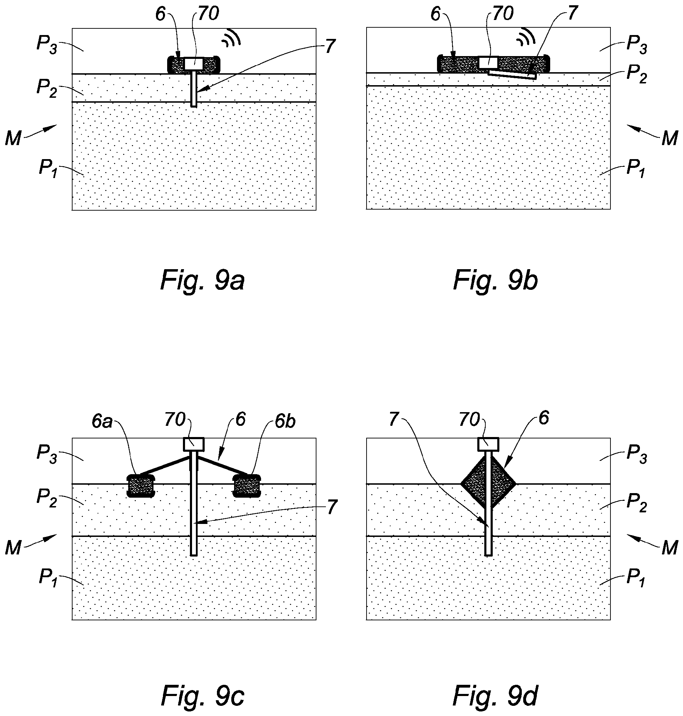

Comme illustré aux figures 9a à 9e, un objet de l'invention est un système de mesures capacitives dans un milieu multiphasique M, comportant :

- un dispositif de flottaison 6, destiné à flotter dans le milieu multiphasique M ;
- au moins un dispositif 7 conforme à l'invention, monté solidaire du dispositif de flottaison 6.

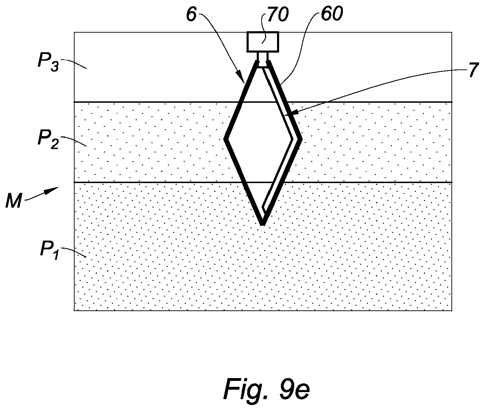

Comme illustré à la figure 9e, le dispositif de flottaison 6 peut comporter une paroi 60 de séparation avec le milieu multiphasique M, la paroi 60 possédant une surface interne, et le dispositif 7 de mesures capacitives est monté à l'intérieur de la paroi 60, en appui contre la surface interne.

Le milieu multiphasique M peut comporter trois phases stratifiées comprenant successivement :

- une première phase liquide $P_1$, électriquement conductrice à la fréquence de travail ;
- une deuxième phase liquide $P_2$, pouvant comporter un ou des polluants tels que des huiles ou des hydrocarbures, et diélectrique à la fréquence de travail ;
- une troisième phase gazeuse $P_3$, diélectrique à la fréquence de travail.

Le dispositif de flottaison 6 est agencé pour flotter à la surface de la deuxième phase liquide $P_2$. Le dispositif de flottaison 6 peut être une bouée. Le dispositif de flottaison 6 peut comporter plusieurs flotteurs 6a, 6b. Le dispositif de flottaison 6 peut être de forme conique.

Bien entendu, le circuit électronique 3 et le circuit de commutation 5 du dispositif 7 de mesures capacitives sont étanches vis-à-vis du milieu multiphasique M. Le dispositif 7 de mesures capacitives comporte avantageusement un module 70 configuré pour transmettre la hauteur de la deuxième phase liquide $P_2$, la transmission pouvant s'effectuer par une communication sans fil. Le dispositif 7 de mesures capacitives est avantageusement alimenté électriquement :

- par une batterie, ou
- par un système de récupération de l'énergie issue du mouvement ou des variations de température du dispositif de flottaison 6, ou
- par une source d'énergie reliée à un capteur solaire,

et ce afin d'obtenir un fonctionnement autonome du dispositif 7 de mesures capacitives.

Pour une application de limitation de la hauteur de la deuxième phase liquide $P_2$, comme illustré aux figures 9a, 9c et 9d, les électrodes d'excitation 1, 2 et la ou les électrodes de contrôle 4 du dispositif 7 de mesures capacitives peuvent être agencées pour s'étendre verticalement, en contact des première et deuxième phases liquides $P_1$, $P_2$, et à une profondeur légèrement supérieure à la hauteur de la deuxième phase liquide $P_2$.

Pour une application de détection de polluants, comme illustré à la figure 9b, les électrodes d'excitation 1, 2 et la ou les électrodes de contrôle 4 du dispositif 7 de mesures capacitives sont avantageusement agencées pour s'étendre entièrement dans la deuxième phase liquide $P_2$, de préférence sensiblement parallèlement à la surface libre de la deuxième phase liquide $P_2$.

L'invention ne se limite pas aux modes de réalisation exposés. L'homme du métier est mis à même de considérer leurs combinaisons techniquement opérantes, et de leur substituer des équivalents, la portée de l'invention étant définie par les revendications.

## Revendications

1. Dispositif de mesures capacitives dans un milieu multiphasique (M), comportant :

   - au moins un couple d'électrodes d'excitation (1, 2), formant un condensateur ;
   - un plan de masse (PM);

- un circuit électronique (3), agencé pour connecter électriquement le couple d'électrodes d'excitation (1, 2) au plan de masse (PM), et configuré pour :

> o appliquer un potentiel électrique (V$_+$, V$_-$) à chaque électrode d'excitation (1, 2) à une fréquence de travail, et
> o mesurer une capacité mutuelle entre le couple d'électrodes d'excitation (1, 2) le dispositif étant **caractérisé en ce qu'**il comporte :
>
>> - au moins une électrode de contrôle (4), agencée à une distance (*l*) du condensateur, et destinée à être insérée dans le milieu multiphasique (M) ;
>> - un circuit de commutation (5) comprenant un commutateur (50) présentant un état ouvert et un état fermé dans lesquels le commutateur (50) respectivement déconnecte et connecte électriquement l'électrode de contrôle (4) au plan de masse (PM); le circuit de commutation (5) étant configuré pour :
>>
>>> o appliquer à l'électrode de contrôle (4) un potentiel électrique commun au plan de masse (PM), lorsque le commutateur (50) est dans l'état fermé, et
>>> o laisser un potentiel électrique flottant pour l'électrode de contrôle (4), lorsque le commutateur (50) est dans l'état ouvert ;

et **en ce que** le circuit électronique (3) est configuré pour mesurer la capacité mutuelle entre le couple d'électrodes d'excitations (1, 2) lorsque le commutateur (50) est dans l'état ouvert et lorsque le commutateur (50) est dans l'état fermé.

2. Dispositif selon la revendication 1, dans lequel, lorsque le milieu multiphasique (M) dans lequel ladite au moins une électrode de contrôle (4) est destinée à être insérée comporte une phase comprenant des espèces électriquement conductrices à la fréquence de travail, lesdites espèces possédant une fréquence de coupure en-dessous de laquelle lesdites espèces égalisent le potentiel électrique, laissé flottant, dans le milieu multiphasique (M) sur la distance (*l*) à laquelle est agencée l'électrode de contrôle (4) du condensateur, le circuit électrique est agencé pour choisir la fréquence de travail à laquelle le potentiel électrique (V$_+$, V$_-$) est appliqué à chaque électrode d'excitation (1, 2) de manière à ce qu'elle soit inférieure ou égale à la fréquence de coupure.

3. Dispositif selon la revendication 2, dans lequel le condensateur présente une distance caractéristique, notée *d* ; et dans lequel la distance (1) à laquelle est agencée l'électrode de contrôle (4) du condensateur, notée *l*, est choisie de sorte que :

$$0 \;<\; l \;<\; 100 \times d\, \frac{f_c}{f}\,,\text{ de préférence}: 0 \;<\; l \;<\; 10 \times d\, \frac{f_c}{f}$$

où :

- $f_c$ est la fréquence de coupure,
- *f* est la fréquence de travail.

4. Dispositif selon l'une des revendications 1 à 3, comportant un ensemble d'électrodes de contrôle (4), agencées à des distances différentes ($l_1$, $l_2$, $l_3$) du condensateur, et destinées à être insérées dans le milieu multiphasique (M) ; le circuit de commutation (5) comportant un commutateur (50) dédié à chaque électrode de contrôle (4).

5. Dispositif selon l'une des revendications 1 à 4, dans lequel le circuit électronique (3) comporte une masse virtuelle (30) reliée à une électrode d'excitation (1, 2) ; et dans lequel le circuit électronique (3) est configuré pour mesurer la capacité mutuelle entre le couple d'électrodes d'excitation (1, 2) par une méthode de type trois fils ou quatre fils.

6. Dispositif selon la revendication 5, dans lequel le circuit électronique (3) comporte un amplificateur opérationnel (31), monté en inverseur, et comprenant :

- une entrée non-inverseuse, reliée au plan de masse (PM) ;
- une entrée inverseuse, reliée à une électrode d'excitation (1, 2).

7. Dispositif selon l'une des revendications 1 à 6, comportant :

- une couche diélectrique (10), comprenant une première surface et une deuxième surface opposée ; le couple d'électrodes d'excitation (1, 2) s'étendant à la première surface de la couche diélectrique (10) ;
- une contre-électrode, s'étendant à la deuxième surface de la couche diélectrique (10), et formant le plan de masse (PM).

8. Dispositif selon l'une des revendications 1 à 7, dans lequel le couple d'électrodes d'excitation (1, 2) est recouvert d'un film diélectrique (20).

9. Dispositif selon l'une des revendications 1 à 8, dans lequel le condensateur formé par le couple d'électrodes d'excitation (1, 2) est sélectionné parmi un condensateur à plaques parallèles, un condensateur à électrodes interdigitées, un condensateur à cylindres coaxiaux.

10. Installation, comportant :

- un réservoir (R) comportant un milieu multiphasique (M) ;
- un dispositif selon l'une des revendications 1 à 9, l'électrode de contrôle (4) étant insérée dans le milieu multiphasique (M).

**Patentansprüche**

1. Vorrichtung für kapazitive Messungen in einem mehrphasigen Milieu (M), Folgendes beinhaltend:

- mindestens ein Paar an Erregerelektroden (1, 2), die einen Kondensator bilden;
- eine Grundplatte (PM);
- eine elektronische Schaltung (3), die angeordnet ist, um das Paar an Erregerelektroden (1, 2) elektrisch mit der Grundplatte (PM) zu verbinden, und konfiguriert zum:

° Anlegen eines elektrischen Potenzials ($V_+$, $V_-$) an jede Erregerelektrode (1, 2) mit einer Arbeitsfrequenz, und
° Messen einer wechselseitigen Kapazität zwischen dem Paar an Erregerelektroden (1, 2);

wobei die Vorrichtung **dadurch gekennzeichnet ist, dass** sie Folgendes beinhaltet:

- mindestens eine Steuerelektrode (4), die in einem Abstand (*l*) von dem Kondensator angeordnet ist, und dazu bestimmt ist, in das mehrphasige Milieu (M) eingeführt zu werden;
- einen Schaltkreis (5), der einen Schalter (50) umfasst, der einen offenen Zustand und einen geschlossenen Zustand aufweist, in denen der Schalter (50) die Steuerelektrode (4) jeweils elektrisch von der Grundplatte (PM) trennt oder damit verbindet; wobei der Schaltkreis (5) konfiguriert ist zum:

° Anlegen eines mit der Grundplatte (PM) gemeinsamen elektrischen Potenzials an die Steuerelektrode (4), wenn der Schalter (50) in dem geschlossenen Zustand ist, und
° schwebend Lassen eines elektrischen Potenzials für die Steuerelektrode (4), wenn der Schalter (50) in dem offenen Zustand ist;

und dadurch, dass die elektronische Schaltung (3) konfiguriert ist, um die wechselseitige Kapazität zwischen dem Paar an Erregerelektroden (1, 2) zu messen, wenn der Schalter (50) im offenen Zustand ist, und wenn der Schalter (50) im geschlossenen Zustand ist.

2. Vorrichtung nach Anspruch 1, wobei, wenn das mehrphasige Milieu (M), in das die mindestens eine Steuerelektrode (4) bestimmt ist, eingeführt zu werden, eine Phase beinhaltet, die elektrisch leitfähige Spezies mit der Arbeitsfrequenz umfasst, die Spezies, die eine Abschaltfrequenz besitzen, unter der die Spezies das schwebend gelassene elektrische Potenzial in dem mehrphasigen Milieu (M) in dem Abstand (*l*) ausgleichen, in dem die Steuerelektrode (4) des Kondensators angeordnet ist, die elektronische Schaltung angeordnet ist, um die Arbeitsfrequenz auszuwählen, mit der das elektrische Potenzial ($V_+$, $V_-$) an jede Erregerelektrode (1, 2) angelegt wird, um kleiner oder gleich der Abschaltfrequenz zu sein.

3. Vorrichtung nach Anspruch 2, wobei der Kondensator einen charakteristischen Abstand, d genannt, aufweist; und wobei der Abstand (1), in dem die Steuerelektrode (4) des Kondensators angeordnet ist, *l* genannt, ausgewählt wird, sodass:

$$0 < l < 100 \times d\,\frac{f_c}{f}, \text{ vorzugsweise: } 0 < l < 10 \times d\,\frac{f_c}{f}$$

wobei:

- $f_c$ die Abschaltfrequenz ist,
- *f* die Arbeitsfrequenz ist.

4. Vorrichtung nach einem der Ansprüche 1 bis 3, welche eine Einheit an Steuerelektroden (4) beinhaltet, die in unterschiedlichen Abständen ($l_1$, $l_2$, $l_3$) von dem Kondensator angeordnet sind, und dazu bestimmt sind, in das mehrphasige Milieu (M) eingeführt zu werden; wobei der Schaltkreis (5) einen Schalter (50) beinhaltet, der jeder Steuerelektrode (4) gewidmet ist.

5. Vorrichtung nach einem der Ansprüche 1 bis 4, wobei elektronische Schaltung (3) eine virtuelle Masse (30) beinhaltet, die an eine Erregerelektrode (1, 2) angeschlossen ist; und wobei die elektronische Schaltung (3) konfiguriert ist, um die wechselseitige Kapazität zwischen dem Paar an Erregerelektroden (1, 2) durch ein Dreidraht- oder Vierdraht-Messverfahren zu messen.

6. Vorrichtung nach Anspruch 5, wobei die elektronische Schaltung (3) einen Operationsverstärker (31) beinhaltet, der als Umschalter montiert ist, und Folgendes umfasst:

   - einen nicht umschaltenden Eingang, der an die Grundplatte (PM) angeschlossen ist;
   - einen umschaltenden Eingang, der an eine Erregerelektrode (1, 2) angeschlossen ist.

7. Vorrichtung nach einem der Ansprüche 1 bis 6, Folgendes beinhaltend:

   - eine dielektrische Schicht (10), die eine erste Oberfläche und eine gegenüberliegende zweite Oberfläche umfasst; wobei sich das Paar an Erregerelektroden (1, 2) über die erste Oberfläche der dielektrischen Schicht (10) erstreckt;
   - eine Gegenelektrode, die sich über die zweite Oberfläche der dielektrischen Schicht (10) erstreckt, und die Grundplatte (PM) bildet.

8. Vorrichtung nach einem der Ansprüche 1 bis 7, wobei das Paar an Erregerelektroden (1, 2) mit einem dielektrischen Film (20) bedeckt ist.

9. Vorrichtung nach einem der Ansprüche 1 bis 8, wobei der durch das Paar an Erregerelektroden (1, 2) gebildete Kondensator aus einem Parallelplattenkondensator, einem Interdigitalelektrodenkondensator, einem Kondensator mit koaxialen Zylindern ausgewählt ist.

10. Installation, Folgendes beinhaltend:

   - einen Behälter (R), der ein mehrphasiges Milieu (M) beinhaltet;
   - eine Vorrichtung nach einem der Ansprüche 1 bis 9, wobei die Steuerelektrode (4) in das mehrphasige Milieu (M) eingeführt ist.

**Claims**

1. A device for capacitive measurements in a multiphase medium (M), including:

   - at least one pair of excitation electrodes (1, 2), forming a capacitor;
   - a ground plane (PM);
   - an electronic circuit (3), arranged to electrically connect the pair of excitation electrodes (1, 2) to the ground plane (PM), and configured to:

o apply an electrical potential (V+, V) to each excitation electrode (1, 2) at a working frequency, and
o measure a mutual capacity between the pair of excitation electrodes(1, 2);

the device being **characterised in that** it includes: - at least one control electrode (4), arranged at a distance ( $l$ ) from the capacitor, and intended to be inserted into the multiphase medium (M);
- a switching circuit (5) comprising a switch (50) having an open state and a closed state in which the switch (50) electrically both disconnects and connects the control electrode (4) to the ground plane (PM); the switching circuit (5) being configured to:

o apply to the control electrode (4) a common electric potential to the ground plane (PM) when the switch (50) is in the closed state, and
o leave a floating electric potential for the control electrode (4) when the switch (50) is in the open state;

and **in that** the electronic circuit(3) is configured to measure the mutual capacitance between the pair of excitation electrodes (1, 2) when the switch (50) is in the open state and when the switch (50) is in the closed state.

2. The device according to claim 1, wherein when the multiphase medium (M), in which said at least one control electrode (4) is intended to be inserted, includes a phase comprising electrically conductive species at the working frequency; said species having a cut-off frequency below which said species equalise the electric potential, left floating, in the multiphase medium (M) over the distance ( $l$ ) at which the control electrode (4) of the capacitor is arranged, the electric circuit is configured to select the working frequency at which the electric potential (V+, V) is applied to each excitation electrode (1, 2) so that it is less than or equal to the cut-off frequency.

3. The device according to claim 2, wherein the capacitor has a characteristic distance, denoted d;
and wherein the distance (7) at which the control electrode (4) of the capacitor, denoted 7, is arranged, is selected such that:

$$0 < l < 100 \times \mathrm{dy}, \text{ preferably: } 0 < l < 10 \times \mathrm{dy}$$

where:

- $f_c$ is the cut-off frequency,
- $f$ is the working frequency.

4. The device according to any one of claims 1 to 3, including a set of control electrodes (4), arranged at different distances ( $l_1$, $l_2$, $l_3$ ) from the capacitor, and intended to be inserted into the multiphase medium (M); the switching circuit (5) including a switch (50) dedicated to each control electrode (4).

5. The device according to any one of claims 1 to 4, wherein the electronic circuit (3) includes a virtual ground (30) connected to an excitation electrode (1, 2); and wherein the electronic circuit (3) is configured to measure the mutual capacitance between the pair of excitation electrodes (1, 2) by a three-wire or four-wire method.

6. The device according to claim 5, wherein the electronic circuit (3) includes an operational amplifier (31), mounted as an inverter, and comprising:

- a non-inverting input, connected to the ground plane (PM);
- and inverting input, connected to an excitation electrode (1, 2).

7. The device according to any one of claims 1 to 6, including:

- a dielectric layer (10), comprising a first surface and a second opposite surface; the pair of excitation electrodes (1, 2) extending to the first surface of the dielectric layer (10);
- a counter-electrode, extending to the second surface of the dielectric layer (10), and forming the ground plane (PM).

8. The device according to any one of claims 1 to 7, wherein the pair of excitation electrodes (1, 2) is covered with a dielectric film (20).

9. The device according to any one of claims 1 to 8, wherein the capacitor formed by the pair of excitation electrodes (1, 2) is selected from a parallel-plate capacitor, an interdigitated electrode capacitor, a coaxial-cylinder capacitor.

10. An installation, including:

    - a reservoir (R) including a multiphase medium (M);
    - a device according to any one of claims 1 to 9, the control electrode (4) being inserted into the multiphase medium (M).

Fig. 1

Fig. 2

Fig. 3

**Fig. 4**

**Fig. 5**

**Fig. 6**

Fig. 7

Fig. 8

Fig. 9a

Fig. 9b

Fig. 9c

Fig. 9d

*Fig. 9e*

**RÉFÉRENCES CITÉES DANS LA DESCRIPTION**

**Documents brevets cités dans la description**

- US 7258005 B